# EUROPÄISCHE PATENTSCHRIFT

(11) **EP 1 552 036 B1**
(45) Veröffentlichungstag und Bekanntmachung des Hinweises auf die Patenterteilung: **30.12.2009**
(21) Anmeldenummer: 03750143.4
(22) Anmeldetag: 10.10.2003
(51) Int. Cl.: C23C 30/00

(54) **ZERSPANUNGSWERKZEUG MIT NIEDRIGEM REIBWERT**
CUTTING TOOL WITH LOW FRICTION COEFFICIENT
OUTIL D'ENLÈVEMENT DE COPEAUX A FAIBLE COEFFICIENT DE FRICTION

(30) Priorität: 14.10.2002 AT 6782002
(43) Veröffentlichungstag der Anmeldung: 13.07.2005
(73) Patentinhaber: CERATIZIT Austria Gesellschaft m.b.H., 6600 Reutte /Tirol (AT)
(72) Erfinder: KATHREIN, Martin, A-6600 Reutte (AT); MITTERER, Christian, A-8700 Leoben (AT); SCHLEINKOFER, Uwe, A-6600 Reutte (AT)
(86) Internationale Anmeldenummer: PCT/AT2003/000307
(87) Internationale Veröffentlichungsnummer: WO 2004/035864

(56) Entgegenhaltungen:
- EP-A- 0 441 262
- EP-A- 0 846 784
- EP-A- 1 054 075
- EP-A- 1 127 959
- EP-A- 1 172 460
- WO-A-02/40734
- WO-A-97/04142
- FR-A- 2 796 399
- US-A- 3 945 807
- US-A- 4 605 343
- US-A- 4 728 448
- US-A- 5 268 216
- US-A- 5 649 994
- US-B1- 6 338 879
- PATENT ABSTRACTS OF JAPAN Bd. 0091, Nr. 96 (C-297), 13. August 1985 (1985-08-13) & JP 60 063365 A (TANAKA KIKINZOKU KOGYO KK), 11. April 1985 (1985-04-11)

## Beschreibung

Die Erfindung betrifft ein Zerspannungswerkzeug bestehend aus einem Grundkörper aus einem Werkstoff der Gruppe Hartmetalle, Cermets, Hartstoffe und Werkzeugstähle mit zumindest einem auf Verschleiß und Reibung beanspruchten Oberflächenbereich mit einer bezogen auf den Grundkörper unterschiedlichen chemischen Zusammensetzung.

Hartmetalle, Cermets, Hartstoffe und Werkzeugstähle werden für Zerspannungswerkzeuge eingesetzt, die einer hohen verschleißenden Beanspruchung ausgesetzt sind. Unter Hartmetall versteht man einen Verbundwerkstoff, der aus einer Hartstoffphase und einem metallischen Binder aufgebaut ist. Die Werkstoffgruppe der Cermets umfasst alle Werkstoffe, die aus einer oder mehreren keramischen Phasen und aus einer oder mehreren metallischen Phasen aufgebaut sind. Unter Hartstoffe werden alle Stoffe mit einer Härte von >1000 HV zusammengefasst. Dies sind Verbindungen von Elementen der IVa bis VIa Gruppen des Periodensystems mit den Elementen Kohlenstoff, Stickstoff, Bor oder Silizium. Jedoch auch Diamant, kubisches Bornitrid, Siliziumkarbid, Aluminiumnitrid, Sialone, Aluminiumoxid, Aluminiumnitrid und Siliziumnitrid, um die wichtigsten zu nennen, fallen in diese Werkstoffgruppe. Werkzeugstähle sind nach DIN 17 350 Stähle, die durch ihre Anwendung in Werkzeugen definiert sind.

Um die Verschleißfestigkeit zu erhöhen, werden speziell auf Hartmetallen, Cermets und Werkzeugstählen auch hochverschleißfeste Hartstoffschichten auf der Basis von Karbiden, Nitriden, Boriden, Siliziden und Oxiden aufgebracht. Diese Schichten weisen Härten auf, die üblicherweise im Bereich 1500 HV bis 4000 HV liegen. Beispielhaft sei auf Ein- oder Mehrlagenschichten bestehend aus Titancarbid, Titannitrid, Titancarbonitrid oder Aluminiumoxid verwiesen.

In der nachfolgenden Beschreibung wird das auf Verschleiß und Reibung beanspruchte Werkzeug der Einfachheit wegen als Verschleißkörper bezeichnet. Im Beanspruchungsfall umfasst das tribologische System neben diesem Verschleißkörper noch den Verschleiß und Reibung verursachenden Gegenkörper, gegebenenfalls Zwischenstoffe, die einwirkenden Kräfte, den Bewegungsablauf und die Umgebungseinflüsse. Speziell wenn die einwirkenden Kräfte und die Relativgeschwindigkeit zwischen Verschleißkörper und Gegenkörper hoch sind, kommt es im Grenzbereich Verschleißkörper / Gegenkörper zu einer deutlichen Temperaturerhöhung. So werden an der Oberfläche eines Zerspanungswerkzeuges Temperaturen von 1000°C und darüber gemessen. Die Ursachen dafür sind die Verformungs- und Trennarbeit in der Scherzone, Reibung des Spanes an der Spanfläche und Reibung des Werkstückes an der Freifläche. Jedoch auch im Falle von Bauteilen, die beispielsweise als Umformwerkzeuge eingesetzt werden, kommt es zu einer deutlichen Erhöhung der Oberflächentemperatur. So treten bei Ziehsteinen Temperaturspitzen von 1100°C auf. Um diese Temperaturerhöhung so gering wie möglich zu halten, werden Schmier- bzw. Kühlschmiermittel in Form von Flüssigkeiten, Suspensionen oder Dispersionen, die kontinuierlich zugeführt werden, eingesetzt.

Neben Schmier- bzw. Kühlschmiermitteln, die im Beanspruchungsfall zugeführt werden, sind auch Lösungen bekannt, sogenannte Feststofftrockenschmierfilme auf dem Verschleißkörper abzuscheiden. Diese Festschmierstoffe weisen zumeist einen Kristallaufbau mit stark richtungsabhängigen Bindungskräften auf. Beispiele dafür sind Graphit, hexagonales Bornitrid und Molybdändisulfid. Eine wirkungsvolle Verminderung des Reibwertes wird bei MoS₂ nur bis 500°C beobachtet, da bei höheren Temperaturen Sublimation auftritt. Bornitrid und Graphit sind unter oxidierenden Bedingungen bis ca. 900°C beständig.

In der DD 202 898 wird vorgeschlagen auf Schnitt-, Stanz-, Zieh- und Zerspanungswerkzeugen oder Lagern Molybdändisulfid durch Sputtern aufzutragen. Um eine entsprechende Schmierwirkung zu erzielen, soll diese Schicht eine hexagonale Gitterstruktur aufweisen.
Auch die EP 0 534 905 schlägt eine PVD-Beschichtung von Zerspanungswerkzeugen mit Molybdänsulfid vor. Diese Sulfidschichten sind sehr weich und werden rasch abgerieben. Es sind zwar die Reibungskräfte auch nach dem Abreiben der Schicht durch in die Randzone inkorporierte Partikeln vermindert, jedoch dies nicht in ausreichendem Maße. Um die Standzeit dieser Schichten zu erhöhen, wurden diverse Schichtkomposite vorgeschlagen.
So beschreibt die WO 00/52223 eine Viellagenschicht mit der Schichtfolge Mo-reiche Schicht / MoS₂-reiche Schicht.
Die WO 97/04142 beschreibt ein Verfahren zur gleichzeitigen Abscheidung von MoS₂ und einem Metall oder einer Metallverbindung wie Titan oder Titannitrid mittels eines speziellen PVD-Verfahrens. Jedoch ist auch bei dieser Schicht bei Einstellung einer ausreichenden Verschleißbeständigkeit, die durch einen hohen Anteil an beispielsweise Titannitrid erreicht werden kann, die reibungsvermindernde Wirkung nicht ausreichend.
Auch Oxide als Feststoffschmiermittel wurden untersucht. So wurden Vanadium- und Wolframoxide mit im Bezug auf den Sauerstoffgehalt unterstöchiometrischer Zusammensetzung vorgeschlagen. Diese Oxide bilden sogenannte Magneliphasen und sind unter oxidierendem Milieu bis zu hohen Temperaturen stabil. Die reibungsverminderde Wirkung ist im Falle hoher Lastkollektive und hoher Relativgeschwindigkeiten zwischen Verschleißkörper und Gegenkörper jedoch nicht ausreichend.

Die US-A 4 605 343 beschreibt ein Schneidwerkzeug aus Hartmetall, auf welchem ein polykristalliner. Diamantfilm abgeschieden ist. Auf dem Diamantfilm ist eine weitere Schicht aus Kupfer aufgetragen. Zwischen dem Diamantfilm und der Kupferschicht können weitere metallische Schichteh, z.8. aus Gold, Platin, Kupfer, Nickel, Silber oder Silber-Kupfer ausgebildet sein. Die Kupferschicht wirkt dabei als Wärmesenke. Die Gold, Platin, Kupfer, Nickel, Silber oder Silber-Kupfer Zwischenschicht hat die Funktion einer Schutzschicht. In der US-A 4 728 448 ist eine selbstschmierende abriebfeste Beschichtung für Verbrennungsmotoren offenbart. Die Beschichtung besteht aus einem Chromkarbid, das mit einer Ni-Al oder Ni-Cr-Legierung, Ag und CaF₂-BaF₂ vermischt ist und dann z.B. auf ein Inconel 750 Substrat durch Plasmaspritzen aufgebracht wird. Gemäß der US-A- 4 728 448 wird die gute Schmierwirkung der Fluoride bei hohen Temperaturen mit der guten Schmierwirkung von Silber im festen Zustand bei niedrigen Temperaturen kombiniert.

Die US-A 3 945 807 beschreibt einen Bohrer aus Hartmetall, der zum Bohren von Leiterplatten verwendet wird und mit Edelmetall, z.B. Au, Ag oder Pt beschichtet ist. Aus der US-A 3 945 807 geht hervor, dass die Edelmetalischicht aufgrund der guten Leitfähigkeit und der Feststoffschmierwirkung vorteilhaft ist. Die CH 683 844 A5 beschreibt ein Gleitsystem, das eine Titankarbidschicht und eine Feststoffschmierrnittelschicht aus Blei oder Silber umfasst.

Die US 5 100 701 beschreibt eine Beschichtung, die aus einem Metallnitrid und einem festen Gleitmittel besteht, wobei das feste Gleitmittel aus metallischem Silber, Eisen oder einer Nickellegierung bestehen kann.

Aufgabe der vorliegenden Erfindung ist daher die Bereitstellung eines Werkzeuges mit hoher Verschteißbeständigkeit und einem, im Kontakt mit dem Verschleißkörper niedrigen Reibwert.

Erfindungsgemäß wird diese Aufgabe durch ein Zuspannungswerkzeug gemäß Auspruch 1 gelöst.

Beim erfindungsgemäßen Zuspannungswerkzeug bildet sich in-situ ein flüssiger Schmierfilm aus. Unter in-situ ist zu verstehen, dass sich eine oder mehrere flüssige, als Schmierfilm fungierende Phase(n) erst im Beanspruchungsfall bildet bzw. bilden. Diese Phase(n) liegt bzw. liegen, wenn der Verschleißkörper keiner Beanspruchung unterliegt, im festen Zustand vor. Die Verringerung des Reibwerts tritt im wesentlichen erst bei Temperaturen auf, wo zumindest teilweise eine oder mehrere flüssige Phase(n) auftritt bzw. auftreten. Durch geeignete Wahl dieser Phase(n) ist es möglich, beanspruchungskontrolliert den Reibwert zu senken. Darunter ist zu verstehen, dass die Schmierfilmbildung dann auftritt, wenn der Verschleißkörper eine bestimmte Oberflächentemperatur erreicht. Damit ist es möglich die Werkzeug standzeit deutlich zu erhöhen, wie dies in den Beispielen dokumentiert ist. Für die Auswahl dieser in-situ einen flüssigen Schmierfilm bildenden Phase(n) kommen Metalle und Legierungen in Frage, die im Beanspruchungsfall bei Erreichen der kritischen Einsatztemperatur teilweise oder vollständig in den flüssigen Zustand übergehen. Es kommen jedoch auch Metalle und, Legierungen in Frage, die im Beanspruchungsfall durch Oxidation, Zersetzung oder sonstiger chemischer Reaktion Phasen bilden, die bei Erreichen der kritischen Einsatztemperatur teilweise oder vollständig in den flüssigen Zustand übergehen. Dieser flüssige Zustand kann dabei nur kurzzeitig und/oder lokal auftreten, um Temperaturspitzen zu vermeiden. Im Regelfall ist der Verschleißkörperaufbau so gewählt, dass sich im Belastungsfall immer eine oder mehre flüssige Phasen ausbilden. Erfindungsgemaβ sind Au, Cu oder Ag oder deren Legierungen geeignet.

Bei der Werkzeugherstellung kann auf bewährte Technologien zurückgegriffen werden. So kann der auf Reibung und Verschleiß beanspruchte Oberflächenbereich mittels Beschichtungsverfahren, Implantierverfahren oder durch pulvermetallurgische Verfahrenstechniken hergestellt werden. Die reibungsvermindernd wirkenden Phasen können einen gestuften oder einen gradierten Konzentrationsverlauf aufweisen. Beispiele für einen gestuften Konzentrationsverlauf sind Zwei- oder Mehrlagenschichten. Im Falle einer Zweilagenschicht ist die dem Grundkörper nähere Lage vorteilhafterweise aus einer oder mehreren Hartstoffphasen aufgebaut.

Hartstoffphasen sind die Oxide, Nitride, Karbide, Karbonitride und Boride der Elemente Al, Ti, Zr und/oder Hf. Die äußere, dem Verschleiß und Reibung verursachenden Körper benachbarte Lage enthält eine oder mehrere feste metallische Phase (n), die im Beanspruchungsfall teilweise oder vollständig in den flüssigen Zustand übergeht bzw. übergehen oder die im Beanspruchungsfall beispielsweise durch Zersetzung oder Oxidation eine oder mehrere Phase(n) ausbildet bzw. ausbilden, die beim Kontakt mit dem Gegenkörper aufschmilzt bzw. aufschmelzen. Der erfindungsgemäße Oberflächenbereich des Verschleißkörpers kann auch als Mehrlagenschicht ausgeführt sein, mit der abwechselnden Schichtfolge Hartstoffschicht und reibungsvermindernde Schicht.

Die im flüssigen Zustand reibungsvermindernden Phasen können jedoch auch in fein verteilter Form in eine Hartstoffschicht mittels Co-Beschichtungsverfahren eingelagert werden. Unter fein verteilter Form ist zu verstehen, dass die Größe der reibungsvermindemd wirkenden Phasen im Nano- bis Mikrometerbereich liegt.
Als besonders geeignete Beschichtungstechniken sind PACVD und PVD-Verfahren und hier wiederum das Sputtern zu nennen.
Ein gradierter Konzentrationsverlauf kann durch Implantierverfahren erzielt werden. So können beispielsweise Metallatome in eine Hartstoffschicht eingebracht werden. Es eignen sich dazu beispielsweise Ag oder Au, die im Beanspruchungsfall nicht oxidieren und durch Aufschmelzen den Reibwert senken. Es können jedoch auch Elemente wie beispielsweise Mo, W oder V eingelagert werden, die im Beanspruchungsfall durch beispielsweise Oxidation Phasen ausbilden, die im schmelzflüssigen Zustand reibungsvermindemd wirken.

Der Verschleißkörper kann so gestaltet sein, dass die gesamte Oberfläche den erfindungsgemäßen, reibungsvermindernden Aufbau aufweist. Dies ist dann fertigungstechnisch sinnvoll, wenn große Bereiche auf Verschleiß und Reibung beansprucht werden. Auch bei Anwendung von PVD- und CVD-Beschichtungsverfahren ist es üblicherweise kostengünstiger, die gesamte Oberfläche des Verschleißkörpers zu beschichten. Die erfindungsgemäße Ausgestaltung der Verschleißkörperoberfläche kann jedoch auch nur lokal durchgeführt werden. Dies kann beispielsweise bei Anwendung von implantier- oder Slurryverfahrenstechniken technologisch sinnvoll sein.

Die erfindungsgemäße Werkzeug- bzw. Bauteilgestaltung kann bei einer Vielzahl von Anwendungen zu einer Standzeiterhöhung führen. Beispielhaft seien dabei Werkzeuge für die spanende Metallbearbeitung genannt. Die erfindungsgemäße Ausgestaltung der Oberfläche verhindert lokale, thermische Überbelastungen.
Damit treten Werkzeugschädigungen, wie beispielsweise Risse, erst nach längerer Beanspruchungszeit auf. Wirtschaftliche und umweltschonende Verfahrenstechniken, wie die Trockenbearbeitung und die Minimalmengenschmierung können bei Verwendung erfindungsgemäßer Bauteile bzw. Werkzeug einfacher und kostengünstiger realisiert werden.

Im Folgenden wird die Erfindung anhand von Ausführungsbeispielen näher beschrieben.

### Beispiel 1

Es wurden Hartmetallproben der Zusammensetzung WC - 10 Gew.% Co - 0,3 Gew.% VC mittels üblicher Methoden hergestellt. Durch Co-Sputtern mittels reaktiver Kathodenzerstäubung wurden unter Verwendung eines TiAl und eines Ag Targets TiₓAl_{y}N_{1-x-y}/Ag Beschichtungen hergestellt, mit x = 0,165 und y = 0,335. Die Schichtdicke der einlagigen TiAlN/Ag-Nanocomposite-Schichten betrug 2,5 - 3 µm. Der Ag Gehalt in den Schichten wurde von 0,1 Gew.% bis 30 Gew.% variiert.

Das tribologische Verhalten wurde mittels eines Kugel / Scheibe-Tribometers bestimmt, wobei die Kugel aus dem Kohlenstoffstahl Ck60 und die Scheibe aus dem TiAIN/Ag-beschichteten Hartmetall bestand.

Folgende Prüfparameter kamen zur Anwendung:
Normalkraft= 2 N
Relativgeschwindigkeit=10 cm/s
Radius der Verschleißspur= 5 mm
Gleitweg= 1000 m.
   Bei Raumtemperatur konnten zwischen den Reibpartnern Ck60-Stahl und den beschichteten Hartmetallproben Reibwerte von µ = 0,5 - 0,7 gemessen werden. Bei einer Prüftemperatur von 1000°C betrugen die Reibwerte µ 0,08 - 0,35. Vergleichweise wurden auch die Reibwerte unbeschichteter Hartmetallproben identer Zusammensetzung ermittelt. Diese betrugen bei Raumtemperatur 0,55 - 0,78 und bei 1000°C 0,69 - 0,88.

### Beispiel 2

Ein handelsüblicher Hartmetallschneideinsatz der Zusammensetzung WC-6 Gew.%Co der Type CNMA 120408 wurde mittels Laserablation (Nd:YAG-LASER-1064nm) strukturiert. Auf der Oberfläche wurden dadurch Muster mit nicht periodisch wiederkehrenden Vertiefungen gebildet. Die Vertiefungen hatten einen Durchmesser von und eine Tiefe im Bereich von 80 µm und 150 µm. Auf diesen so strukturierten Schneideinsatz wurde zunächst mittels CVD-Technik eine 12 µm dicke TiCN/Al₂O₃ CVD-Schicht aufgebracht. In weiterer Folge wurde eine 2 µm dicke, einlagige Ag-Schicht durch reaktive Kathodenzerstäubung mittels unbalancierter Magnetronanordnung unter Verwendung von Argon als Arbeitsgas aufgebracht. So hergestellte Schneideinsätze und Vergleichsproben wurden Zerspanungsversuchen unterzogen, wobei nach jeweils zwei Minuten Verschleißzeit die Verschleißmarkenbreite an der Spanfläche und an der Freifläche ermittelt wurde.
Die Vergleichsproben unterschieden sich von den erfindungsgemäßen Proben nur darin, dass diese keine Ag-Schicht aufwiesen.
Versuchsbedingungen des Zerspanungsversuches:
Zerspanter Werkstoff: Ck45 Welle (Durchmesser ca. 300 mm)
V_{c} (Schnittgeschwindigkeit) = 320 m/min
f (Vorschub) = 0,3 mm / Umdrehung
aₚ (Schnitttiefe) = 2,0 mm

Es zeigt sich, dass nach 8 min. Testzeit bei den erfindungsgemäßen Proben die Verschleißmarkenbreite an der Spanfläche (Kolkmarkenbreite) bei 0,7 mm und die Verschleißmarkenbreite der Freifläche bei 0,25 mm lagen. Die entsprechenden Werte der Vergleichsproben lagen bei 1,0 mm bzw. bei 0,35 mm.

## Patentansprüche

1. Zerspanungswerkzeug, bestehend aus einem Grundkörper aus einem Werkstoff der Gruppe Hartmetalle, Cermets, Hartstoffe und Werkzeugstähle, das im auf Verschleiß und Reibung beanspruchten Oberflächenbereich mit einer Hartstoffschicht versehen ist, die bezogen auf den Grundkörper eine unterschiedliche chemische Zusammensetzung aufweist und zumindest eine Hartstoffphase aus der Gruppe der Oxide, Nitride, Karbide und Boride der Elemente Al, Ti, Zr und/oder Hf enthält,
**dadurch gekennzeichnet,**
**dass** in der Hartstoffschicht fein verteilt Ag, Cu und/oder Au eingelagert ist, wobei die Schmelz- oder Solidustemperatur von Ag, Cu und/oder Au oder von den im Beanspruchungsfall von Ag, Cu und/oder Au zumindest teilweise gebildeten Phasen niedriger ist, als die im Beanspruchungsfall beim Kontakt mit dem Verschleiß und Reibung verursachenden Körper im Oberflächenbereich des Werkzeuges maximal auftretende Temperatur.

2. Werkzeug nach Anspruch 1, **dadurch gekennzeichnet, dass** sich im Beanspruchungsfall beim Kontakt mit dem Verschleiß und Reibung verursachenden Körper zumindest lokal in dem Verschleiß und Reibung ausgesetzten Oberflächenbereich des Werkzeuges eine flüssige Phase ausbildet, die Reibwert-vermindemd wirkt.

3. Werkzeug nach Anspruch 1 oder 2, **dadurch gekennzeichnet, dass** die Hartstoffschicht Ag enthält.

## Claims

1. Cutting tool, consisting of a basic body made of a material from the group comprising hard metals, cermets, hard substances and tool steels, which in the surface region subjected to wear and friction is provided with a hard-substance coating which exhibits a different chemical composition relative to the basic body and contains at least one hard-substance phase from the group comprising the oxides, nitrides, carbides and borides of the elements Al, Ti, Zr and/or Hf,
**characterised in that**
finely distributed Ag, Cu and/or Au is embedded in the hard-substance coating, the melting-temperature or solidus temperature of Ag, Cu and/or Au or of the phases formed at least partly in the case of stress of Ag, Cu and/or Au being lower than the maximally occurring temperature in the case of stress upon contact with the body causing wear and friction in the surface region of the tool.

2. Tool according to Claim 1, **characterised in that** in the case of stress upon contact with the body causing wear and friction a liquid phase is formed at least locally in the surface region of the tool exposed to wear and friction, which acts to reduce the coefficient of friction.

3. Tool according to Claim 1 or 2, **characterised in that** the hard-substance coating contains Ag.

## Revendications

1. Outil d'enlèvement de copeaux constitué d' un corps de base en un matériau du groupe formé par les métaux durs, cermets, substances dures et aciers à outils qui est pourvu, dans la zone de surface sollicitée en abrasion et en friction, d'une couche de substance dure dont la composition chimique est différente de celle du corps de base et qui contient au moins une phase de substance dure du groupe formé par les oxydes, nitrures, carbures et borures des éléments Al, Tl, Zr et/ou Hf,
**caractérisé en ce que** de l'Ag, du Cu et/ou de l'Au finement réparti est dispersé dans la couche de substance dure d' une manière telle que la température de fusion ou de solidus d'Ag, Cu et/ou Au ou de phases au moins partiellement formées par l'Ag, le Cu et/ou l'Au en cas de sollicitation est inférieure à la température maximale apparaissant en cas de sollicitation dans la zone de surface de l'outil lors du contact avec le corps qui provoque l'abrasion et la friction.

2. Outil selon la revendication 1 **caractérisé en ce qu'**une phase liquide, qui réduit le coefficient de friction, se forme au moins localement, en cas de sollicitation, dans la zone de l'outil soumise à l'abrasion et à la friction lors du contact avec le corps qui provoque l'abrasion et la friction.

3. Outil selon la revendication 1 ou 2 **caractérisé en ce que** la couche de substance dure contient de l'Ag.
